# EUROPEAN PATENT APPLICATION

(11) **EP 2 878 945 A1**
(43) Date of publication of application: **03.06.2015**
(21) Application number: 14192332.6
(22) Date of filing: 07.11.2014
(51) Int. Cl.: G01N 27/90

(54) **Conductive foreign material detecting apparatus**

(30) Priority: 27.11.2013 JP 2013245339
(71) Applicant: Yokogawa Electric Corporation, Tokyo 180-8750 (JP)
(72) Inventor: Takenaka, Kazuma, Tokyo, 180-8750 (JP); Mito, Shinya, Tokyo, 180-8750 (JP); Kato, Satoshi, Tokyo, 180-8750 (JP); Funazaki, Soukichi, Tokyo, 180-8750 (JP)
(74) Representative: Henkel, Breuer & Partner

(57) **Abstract**

A conductive foreign material detecting apparatus includes an exciting coil configured to apply an AC magnetic field to a base substance through which the AC magnetic field passes, a magnetic sensor configured to detect a change of the AC magnetic field caused by a conductive foreign material on a surface of the base substance or in the base substance, a noise reduction coil configured to reduce a noise of substantially the same frequency as the AC magnetic field other than the change of the AC magnetic field by generating predetermined magnetic field to the AC magnetic field, and a current controller configured to control a drive current and a phase of the noise reduction coil so as to make the noise of substantially the same frequency as the AC magnetic field other than the change of the AC magnetic field be minimal.

## Description

### BACKGROUND OF THE INVENTION

### Field of the Invention

The disclosure relates to a conductive foreign material detecting apparatus.

Priority is claimed on Japanese Patent Application No. 2013-245339, filed November 27, 2013, the contents of which are incorporated herein by reference.

### Description of Related Art

Methods of detecting a conductive foreign material by using magnetism includes a detecting method of applying AC (Alternate-Current) magnetic field to a conductive foreign material and a detecting method of applying DC (Direct-Current) magnetic field to a conductive foreign material. In the detecting method of applying DC magnetic field to a conductive foreign material, because the conductive foreign material is to be magnetized, there is a need that the conductive foreign material which is a detection object is made of magnetic material. Therefore, non-magnetic material cannot be detected by the detecting method of applying DC magnetic field to a conductive foreign material.

In the detecting method of applying an AC magnetic field to a conductive foreign material, in a case that the conductive foreign material is made of magnetic material, change of magnetic field caused by magnetizing is detected. In a case that the conductive foreign material is made of non-magnetic material, secondary magnetic field generated by eddy current generated in the conductive foreign material by the AC magnetic field is detected. For this reason, by the detecting method of applying the AC magnetic field, the conductive foreign material can be detected regardless of whether the conductive foreign material is made of magnetic material or non-magnetic material. Therefore, in a case that a type of the conductive foreign material is not identified, the detecting method of applying the AC magnetic field is very effective.

As methods of detecting a conductive foreign material which is a non-magnetic material, a method of using a detection coil and a method of using a magnetic sensor are known. In the method of using a detection coil, as described in Japanese Unexamined Patent Application Publication No. 2010-230605, the conductive foreign material is detected by detecting change in inductance of the detection coil, which is caused by change of magnetic flux, as change in phase. However, in this method, there are problems of low sensitivity, bad frequency characteristic, and growth in size of the detection unit.

The method of using a magnetic sensor includes a method of using a SQUID (Superconducting QUantum Interference Device), a method of using a flux-gate, a method of using a magnetic resistance element, and a method of using a magnetic impedance element. Although the method of using the SQUID is superior in terms of sensitivity, because it needs to be cooled by liquid helium, there are problems of economically inefficiency and growth in size of the detection unit. The method of using the flux-gate has problems of low SNR (Signal-to-Noise Ratio) because of low number of coil turns in a case of small size and bad frequency characteristic. In a case of using the magnetic resistance element or the magnetic impedance element, because requirements of high sensitivity, wide frequency characteristic, and small size are achieved, the method is suitable for detecting the conductive foreign material.

However, intensity of the secondary magnetic field generated by eddy current generated in the conductive foreign material is low. For the reason, there are problems that SNR decreases because of components affecting output of the magnetic sensor in accordance with AC magnetic field from an exciting coil, the components are such as electrical voltage inducted in sensor wirings by the AC magnetic field from the exciting coil, secondary magnetic field generated by eddy current generated in metallic components such as a pin and a magnet disposed around the sensor, and so on. Because the phase of the eddy current delays in accordance with depth from surface, the phase of the secondary magnetic field generated by the eddy current generated in metallic components delays. Because the magnetic field applied to the sensor wirings and the metallic components changes in accordance with inclination of the sensor and a position of the sensor in the magnetic field, amplitude and a phase of an entire background noise of which frequency is substantially same as that of the signal component is not constant. Therefore, each of sensors and apparatuses has individual differences.

In Japanese-Unexamined Patent Application Publication No. H4-221757 and Japanese Unexamined Patent Application Publication No. H8-15229, the method of using the SQID is described. Although a cancelling coil is disclosed in both of the patent references, the cancelling coil is driven by a signal of which amplitude is same as the exciting coil and of which phase is opposite to the exciting coil, and phase control is not performed.

In Japanese Unexamined Patent Application Publication No. 2001-33430, the method of using the flux-gate is described, which is different construction. Although it is described in the patent reference that an amplitude and a phase are controlled, these are controlled to cancel out a noise component generated by direct action of the AC magnetic field from the exciting coil on the magnetic sensor, not to cancel out a noise component indirectly generated by action of the AC magnetic field from the exciting coil on the sensor wirings and the metallic components.

Therefore, by the techniques described in these patent references, it is difficult to suppress the background noise component by reducing the noise component of which frequency is same as the AC magnetic field from the exciting coil.

### SUMMARY

A conductive foreign material detecting apparatus may include an exciting coil configured to apply an AC magnetic field to a base substance through which the AC magnetic field passes, a magnetic sensor configured to detect a change of the AC magnetic field caused by a conductive foreign material on a surface of the base substance or in the base substance, a noise reduction coil configured to reduce a noise of substantially the same frequency as the AC magnetic field other than the change of the AC magnetic field by generating predetermined magnetic field to the AC magnetic field, and a current controller configured to control a drive current and a phase of the noise reduction coil so as to make the noise of substantially the same frequency as the AC magnetic field other than the change of the AC magnetic field be minimal.

### BRIEF DESCRIPTION OF THE DRAWINGS

FIG. 1 is a block diagram illustrating a process of reducing background noises of which frequency is substantially same as that of a signal component before detecting the conductive foreign material.
FIG. 2 is a block diagram illustrating a process of detecting the conductive foreign material.
FIG 3 is a graph illustrating wave shape of an output signal of a magnetic sensor when detecting the conductive foreign material by using the conductive foreign material detecting apparatus.
FIG. 4A is a drawing illustrating a relation between the drive current I and the noise output V_{N} in a case that the phase ϕ is a specific value ϕ₁ and the drive current I is changed.
FIG. 4B is a drawing illustrating a relation between the drive current I and the noise output V_{N} in a case that the phase ϕ is a specific value ϕ₂ and the drive current I is changed.
FIG. 4C is a drawing illustrating a relation between the drive current I and the noise output V_{N} in a case that the phase ϕ is a specific value ϕ₃ and the drive current I is changed.
FIG. 5 is a drawing illustrating a relation between the drive current I of the noise reduction coil 5 and the noise output V_{N} in a case that the drive current I is a fixed value.
FIG. 6 is a flowchart illustrating steps for the current controller 6 to determine the drive current and the phase of the noise reduction coil 5.
FIG. 7 is a drawing illustrating an example of the magnetic sensor having two magnetic resistance elements.
FIG. 8 is a drawing illustrating an example of the bridge circuit 8.
FIG. 9 is a drawing illustrating an example of a conductive foreign material detecting apparatus 1B(1) in a second embodiment.
FIG. 10 is a drawing illustrating an example of an eddy current detecting apparatus 30 and illustrating a block diagram of the eddy current detecting apparatus 30 detecting a defection 16.
FIG. 11 is a drawing illustrating a parallel resonant circuit.
FIG. 12 is a drawing illustrating a series resonant circuit.
FIG. 13 is a drawing illustrating an example of a conductive foreign material detecting apparatus in another embodiment.

### DETAILED DESCRIPTION OF THE EMBODIMENTS

The embodiments of the present invention will be now described herein with reference to illustrative preferred embodiments. Those skilled in the art will recognize that many alternative preferred embodiments can be accomplished using the teaching of the present invention and that the present invention is not limited to the preferred embodiments illustrated herein for explanatory purposes.

First object of some embodiments of the present invention is to provide the conductive foreign material detecting apparatus which can suppress the background noise component by reducing the noise component of which frequency is substantially same as the AC magnetic field from the exciting coil.

### (First Embodiment)

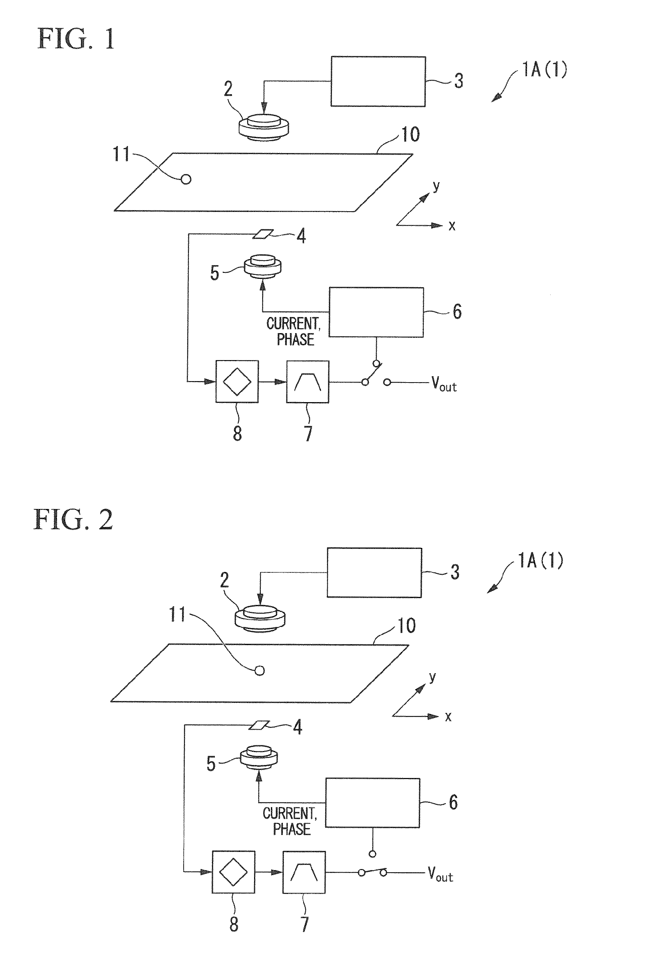

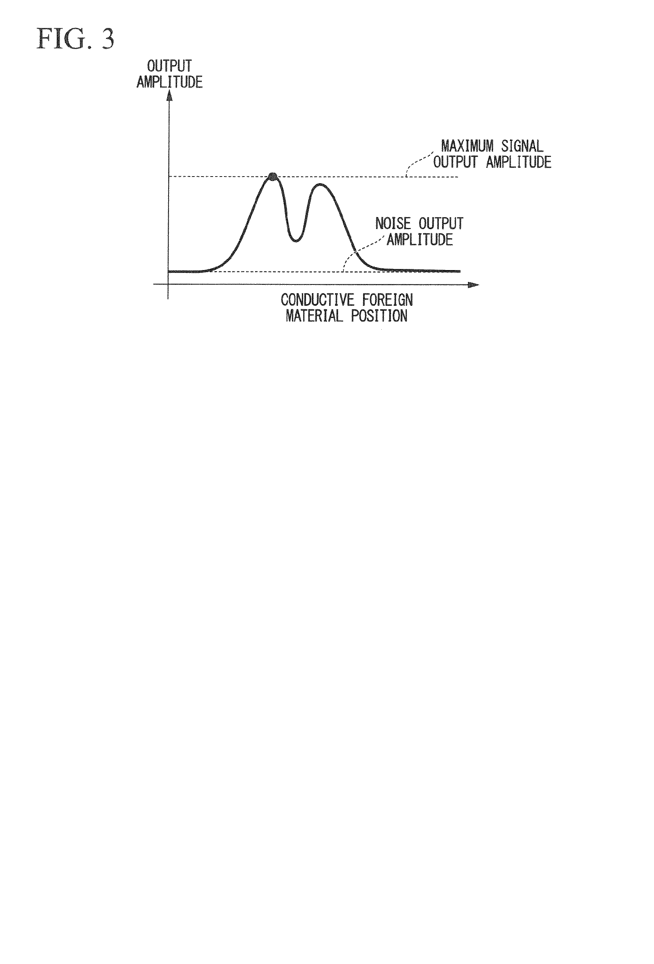

FIG. 1 and FIG. 2 are views of an exemplary constitution of the conductive foreign material detecting apparatus of the present embodiment. FIG. 1 is a block diagram illustrating a process of reducing background noises of which frequency is substantially same as that of a signal component before detecting the conductive foreign material. FIG. 2 is a block diagram illustrating a process of detecting the conductive foreign material. FIG. 3 is a graph illustrating wave shape of an output signal of a magnetic sensor when detecting the conductive foreign material by using the conductive foreign material detecting apparatus.

The conductive foreign material detecting apparatus 1A(1) includes an exciting coil 2, a current controller 3, a magnetic sensor 4, a noise reduction coil 5, a current controller 6, a bandpass filter 7, and a bridge circuit 8.

The exciting coil 2 applies the AC magnetic field to a sheet (base substance) 10 through which the AC magnetic field can pass. In the present embodiment, "a sheet (base substance) 10 through which the AC magnetic field can pass" is, in other words, "a base substance through which a magnetic change caused by the conductive foreign material can pass" or "a base substance through which secondary magnetic field generated by eddy current can pass". The current controller 3 controls a drive current and a phase of the exciting coil 2.

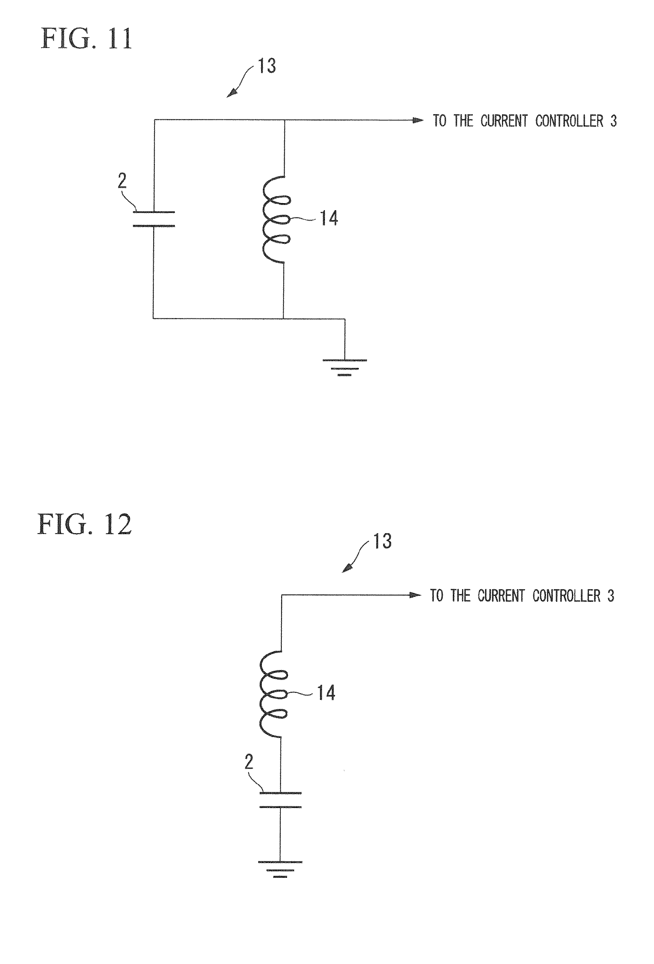

FIG. 11 is a drawing illustrating a parallel resonant circuit, and FIG. 12 is a drawing illustrating a series resonant circuit. As shown in FIG. 11 and FIG. 12, it is more effective that the conductive foreign material detecting apparatus 1A(1) includes a resonant circuit 13 in which a capacitor 14 is connected to the exciting coil 2. The resonant circuit 13 drives the exciting coil 2 at around a resonant frequency of the resonant circuit 13 so that the impedance of the resonant circuit 13 can be smaller and much more current can flow in the exciting coil 2. Therefore, the intensity of the AC magnetic field applied to the conductive foreign material 11 can be increased and the output signal from the magnetic sensor 4 can be increased.

The magnetic sensor 4 (magnetic sensitive element) detects a change of the AC magnetic field caused by the conductive foreign material 11 on a surface of the sheet 10 or in the sheet 10. As the magnetic sensor 4, an anisotropic magnetic resistance element (AMR), a giant magnetic resistance element (GMR), a tunnel magnetic resistance element (TMR), or a magnetic resistance element such as a tunnel magnetic resistance made of a nano-granular film and a soft magnetic thin film, of which electrical resistances change in accordance with applied magnetic field, may be used. Also, as the magnetic sensor 4, a magnetic impedance element of amorphous wires or films made of soft magnetic material, of which electrical impedance changes in accordance with the applied magnetic field, may be used. The magnetic sensor 4 is disposed immediately below the exciting coil 2 so as to make a magnetic sensitive direction of the magnetic sensor 4 be perpendicular to the AC magnetic field generated by the exciting coil 2.

Bias magnetic field may be applied to the magnetic sensor 4 by a bulk magnet (not shown). As the bulk magnet, for example, a SmCo magnet of which main components are samarium and cobalt may be used. For example, the magnet is processed to be cube-shaped of 0.8 square millimeters × 0.5 millimeters. Both faces of magnetic pole faces are 0.8 square millimeters and magnetized.

As the bulk magnet, other than the SmCo magnet of which main components are samarium and cobalt, a neodymium magnet of which main components are neodymium, iron, and boron, a ferrite magnet of which main component is oxidized iron, an alnico magnet of which main components are aluminum, nickel, cobalt, and iron, and a magnet of which main components are iron, chrome, and cobalt may be used. In the present embodiment, the SmCo magnet having high temperature stability and high workability is used.

The output signal component from the magnetic sensor 4 is detected via the bandpass filter 7. The bandpass filter 7 narrows the bandwidth of the output signal component from the magnetic sensor 4 so that the noise component other than the signal component can be suppressed. Therefore, SNR which is a ratio of the output signal component and the noise component can be improved.

Specifically, it is more effective that the bandpass filter 7 includes a vibrator. By using the bandpass filter 7 including the vibrator of high Q value (high selectivity), the bandwidth of the output signal component from the magnetic sensor 4 can be more narrowed, the noise component other than the signal component can be more suppressed. The vibrator is, for example, such as a crystal vibrator, a ceramic vibrator, a silicon vibrator, and so on.

Although an example of the conductive foreign material detecting apparatus 1A(1) including the bandpass filter 7 has been described above, the conductive foreign material detecting apparatus 1A(1) may include a lock-in amplifier instead of the bandpass filter 7.

When the conductive foreign material detecting apparatus 1A(1) performs the conductive foreign material detection, the exciting coil 2 is driven by the current controller 3, and the AC magnetic field is applied. At this time, the background noise is generated directly or indirectly in the output from the magnetic sensor by the AC magnetic field generated by the exciting coil 2. The frequency of the background noise is substantially same as that of the AC magnetic field. The noise reduction coil 5 is disposed so as to minimize the background noise.

The noise reduction coil 5 generates predetermined magnetic field to the AC magnetic field generated by the exciting coil 2 so that the noise component of the same frequency as the AC magnetic field other than the magnetic change can be reduced. The noise reduction coil 5 is controlled in accordance with the signal component passed through the bridge circuit 8 and the bandpass filter 7. The noise reduction coil 5 is disposed under the exciting coil 2 to face the exciting coil 2.

The current controller 6 controls a drive current and a phase of the noise reduction coil 5. By controlling the drive current and the phase of the noise reduction coil 5, the background noise included in the output signal from the magnetic sensor 4 can be reduced.

The conductive foreign material detecting apparatus 1A(1) makes the noise component of the same frequency as the AC magnetic field other than the magnetic change be minimal by controlling the drive current and the phase of the noise reduction coil 5.

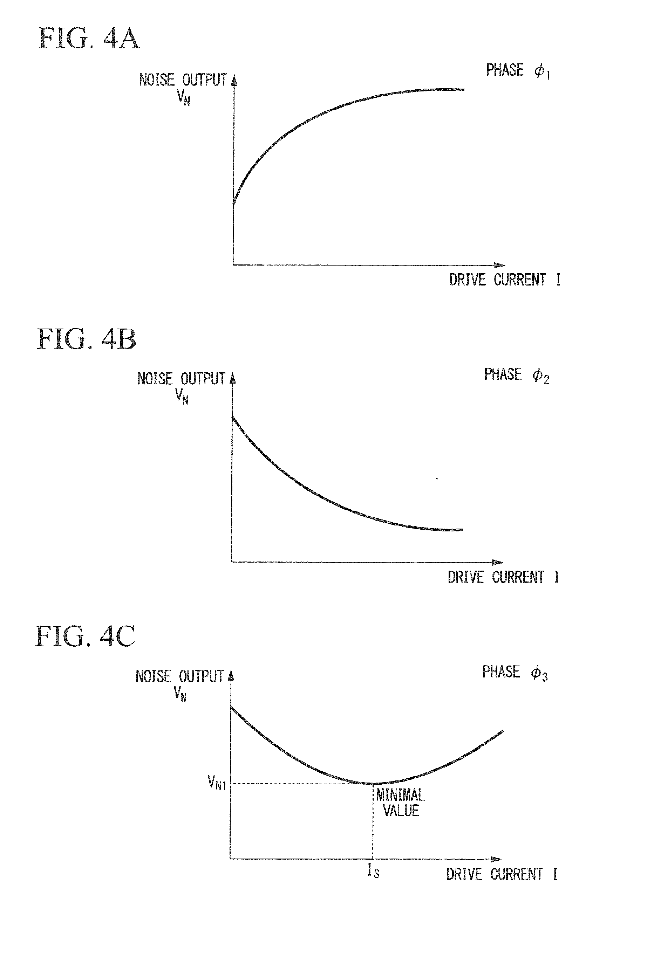

FIGS. 4A, 4B, and 4C are drawings illustrating a relation between the drive current I (horizontal axis) of the noise reduction coil 5 and the noise output V_{N} (vertical axis). FIG. 4A is a drawing illustrating a relation between the drive current I and the noise output V_{N} in a case that the phase ϕ is a specific value ϕ₁ and the drive current I is changed. FIG. 4B is a drawing illustrating a relation between the drive current I and the noise output V_{N} in a case that the phase ϕ is a specific value ϕ₂ and the drive current I is changed. FIG. 4C is a drawing illustrating a relation between the drive current I and the noise output V_{N} in a case that the phase ϕ is a specific value ϕ₃ and the drive current I is changed. When the drive current I is changed, the noise output V_{N} does not always have minimal value. The case examples are individually described below by using FIGS. 4A, 4B, and 4C.

FIG. 4A is a case example that the greater the drive current I is, the greater the noise output V_{N} is. FIG. 4A has a positive slope. FIG. 4B is a case example that the greater the drive current I is, the smaller the noise output V_{N} is. FIG. 4B has a negative slope. Therefore, the graphs shown in FIG. 4A and FIG. 4B do not have any minimal values. To the contrary, FIG. 4C is a case example that the greater the drive current I is, the noise output V_{N} is changed to be downward-convex-shaped. FIG. 4C has a minimal value. The value Is is drive current when a minimal value V_{N1} is observed.

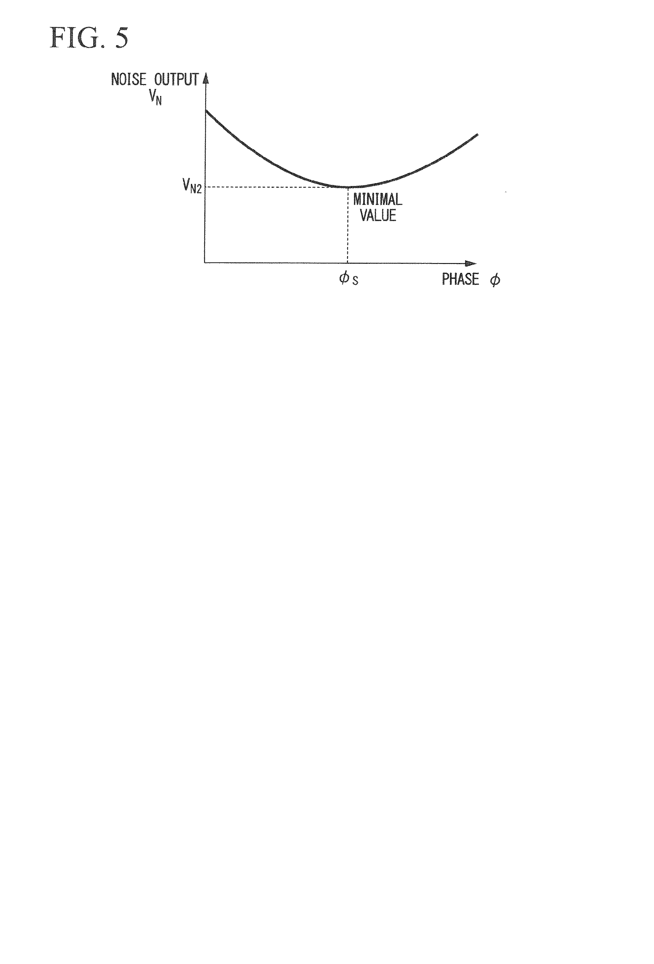

FIG. 5 is a drawing illustrating a relation between the drive current I (horizontal axis) of the noise reduction coil 5 and the noise output V_{N} (vertical axis) in a case that the drive current I is a fixed value. Although only one case example having a minimal value is shown in FIG. 5, same as FIG. 4, the noise output V_{N} does not always have minimal value in a case that the phase ϕ is changed.

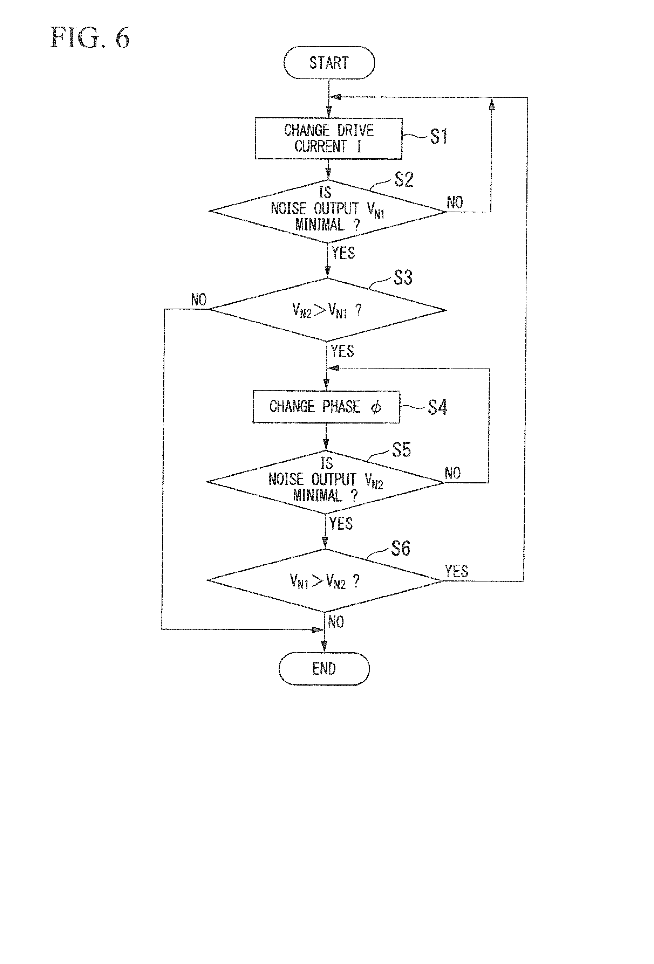

Therefore, a condition (combination of the drive current I and the phase ϕ) that the noise output V_{N} becomes minimum is considered. In the present embodiment, the drive current I_{S} of the minimal value V_{N1} is obtained with changing the drive current I of the noise reduction coil 5. Next, the drive current Is is fixed, and a phase ϕ_{S} of the minimal value V_{N2} is obtained with changing the phase ϕ of the noise reduction coil 5. That is, "a method for obtaining a combination of the drive current I and the phase ϕ to make the noise output be minimum by repeatedly searching the minimal value with changing the drive current I and the phase ϕ" is an outline of the present embodiment. The method of the present embodiment is described below in detail by using FIG. 6.

FIG. 6 is a flowchart illustrating steps for the current controller 6 to determine the drive current and the phase of the noise reduction coil 5. The flowchart represents "a method for obtaining a combination of the drive current I and the phase ϕ to make the noise output be minimum". The flowchart is performed under the condition that the conductive foreign material 11 does not affect.

First, in a first step S1, the current controller 6 obtains the noise output V_{N1} with making the phase ϕ of the noise reduction coil 5 be fixed and changing the drive current I. Next, in a second step S2, the current controller 6 determines whether the noise output V_{N1} is a minimal value or not. This determination is performed in accordance with whether the graph shown in FIG. 4C is observed or not.

In a case that the noise output V_{N1} is not the minimal value, in other words, in a case that the graph shown in FIG. 4A or FIG 4B is observed, the current controller 6 determines "NO", and processing returns to the first step S1. After that, the current controller 6 obtains the noise output V_{N1} with changing the drive current I again. This loop (La : S1→S2→NO→S1) is executed until the minimal value of the noise output V_{N1} is obtained.

By the loop La, in a case that the noise output V_{N1} is the minimal value (in a case where "the combination of the drive current I and the phase ϕ" is obtained), the current controller 6 determines "YES", and processing proceeds to a third step S3.

In the third step S3, the current controller 6 determines whether "the noise output V_{N1} which is the minimal value" is smaller than "noise output V_{N2} in a case of making the drive current I be fixed and changing the phase ϕ" or not. At only first time, a predetermined value is used as the noise output V_{N2}. After that, the noise output V_{N2} obtained in a fifth step S5 described later is used.

In a case that "the noise output V_{N1} which is the minimal value" determined in the second step S2 is smaller than the noise output V_{N2} (YES : V_{N2} > V_{N1}), processing proceeds to a fourth step S4.

In a case that "the noise output V_{N1} which is the minimal value" determined in the second step S2 is greater than or equal to the noise output V_{N2} (YES : V_{N2} < V_{N1} or V_{N2} = V_{N1}), processing does not proceed to the fourth step S4, the processing of this flowchart ends. By the combination of the drive current and the phase at this time, the current controller 6 determines a minimum value of the noise output V_{N} is obtained.

In a case that the current controller 6 determines YES (V_{N2} > V_{N1}) in the third step S3, the current controller 6 obtains the noise output V_{N2} by making the drive current I of the noise reduction coil 5 be fixed and changing the phase ϕ in the fourth step S4.

Next, in a fifth step S5, the current controller 6 determines whether the noise output V_{N2} is the minimal value or not. This determination is performed in accordance with whether the graph shown in FIG. 5 is observed or not.

In a case that the noise output V_{N2} is not the minimal value, in other words, in a case that the minimal value is not observed and monotone increasing or monotone decreasing is observed, the current controller 6 determines "NO", processing returns to the fourth step S4, the current controller 6 changes the phase ϕ again and obtains the noise output V_{N2}. The current controller 6 performs the loop (Lb : S4→S5→NO→S4) repeatedly until the minimal value of the noise output V_{N2} is obtained.

By the loop Lb, in a case that the noise output V_{N2} is the minimal value (in a case where "the combination of the drive current I and the phase ϕ" is obtained), the current controller 6 determines "YES", and processing proceeds to a sixth step S6.

In the sixth step S6, the current controller 6 determines whether "the noise output V_{N2} which is the minimal value" is smaller than "the noise output V_{N1} in a case of making the phase ϕ be fixed and changing the drive current I" or not. At this time, the noise output V_{N1} obtained in the second step S2 is used.

In a case that "the noise output V_{N2} which is the minimal value'' determined in the fifth step S5 is smaller than the noise output V_{N1} (YES : V_{N1} > V_{N2}), processing does not proceeds to END, processing returns to the first step S1 again.

In a case that "the noise output V_{N2} which is the minimal value" determined in the fifth step S5 is greater than or equal to the noise output V_{N1} (YES : V_{N1} < V_{N2} or V_{N1} = V_{N2}), processing does not return to the first step S1, the processing of this flowchart ends. By the combination of the drive current and the phase at this time, the current controller 6 determines a minimum value of the noise output V_{N} is obtained.

As described above, in the present embodiment, the current controller 6 obtains the current value (drive current I) having the minimal value of the noise output V_{N1} by making the phase ϕ of the noise reduction coil 5 be fixed and changing the drive current I. At this current value (drive current I), the current controller 6 obtains the phase ϕ at which the minimal value of the noise output V_{N2} is observed by changing the phase ϕ of the noise reduction coil 5. That is, the current controller 6 repeatedly searches "the minimal value" of the noise output V_{N} with changing the drive current I and the phase ϕ, and the current controller 6 finally obtains the combination of the drive current I and the phase ϕ at which "the minimum value" of the noise output is obtained. By the processing, the noise component included in the output signal from the magnetic sensor 4 can be suppressed to be less level than conventional method.

In the present embodiment described above, although the drive current I is changed first, the phase ϕ may be changed first, and after that, the drive current I may be changed.

FIG. 2 is a block diagram illustrating a process of detecting the conductive foreign material by using the conductive foreign material detecting apparatus 1A(1). The current controller 3 controls the exciting coil 2, and the AC magnetic field is applied to the sheet 10. By applying the AC magnetic field to the conductive foreign material 11 on the sheet 10 from the exciting coil 2, in a case that the conductive foreign material 11 is made of magnetic material, change of the magnetic field is generated by magnetizing. In a case that the conductive foreign material 11 is made of non-magnetic material, secondary change of the magnetic field is generated by eddy current generated in the conductive foreign material 11 by the AC magnetic field.

It is more effective that the magnetic sensor 4 is disposed immediately below the exciting coil 2 and below the sheet 10 including the conductive foreign material 11, and the magnetic sensitive direction of the magnetic sensor 4 is perpendicular to the AC magnetic field caused by the exciting coil 2.

The current controller 6 drives the noise reduction coil 5 by using the drive current and the phase obtained by the method described above at the time of reducing "the background noise component V_{N}". The current controller 6 corrects the background noise component of the same frequency as the AC magnetic field caused by the component affecting the output from the magnetic sensor 4 in accordance with the AC magnetic field from the exciting coil 2 by controlling the drive current and the phase. By this processing, the SNR which is a ratio of the output signal component and the noise component can be improved.

By passing through the bandpass filter 7, filtering out noise caused by elements and environmental magnetic field, the current controller 6 detects the output from the magnetic sensor 4. By this processing, the noise effect can be smaller, and the change of the magnetic field can be detected. Also, by controlling the drive current and the phase with respect to each apparatus, individual difference of the each apparatus can be decreased and the output signal component can be detected stably.

FIG. 3 is a graph illustrating wave shape of an output signal from the magnetic sensor 4 when detecting the conductive foreign material 11 by using the conductive foreign material detecting apparatus 1A(1) shown in FIG. 1 and FIG. 2.

The output signal changes in accordance with a distance between the magnetic sensor 4 and the conductive foreign material 11 in constant AC magnetic field. For this reason, in a case that the conductive foreign material 11 passes through immediately above the magnetic sensor 4 along the magnetic sensitive direction of the magnetic sensor 4, the shape of the output signal is shown in FIG. 3. Because the output signal is caused by the secondary change of the magnetic field generated by eddy current generated in the conductive foreign material 11, the output signal is AC signal. In FIG. 3, the amplitude of the output signal is shown. In a case that the conductive foreign material 11 exists immediately above the magnetic sensor 4, in other words, in a case that the conductive foreign material 11 exists in a narrow area closest to the magnetic sensor 4, the output signal is small because the secondary change of the magnetic field generated by eddy current generated in the conductive foreign material 11 is reduced.

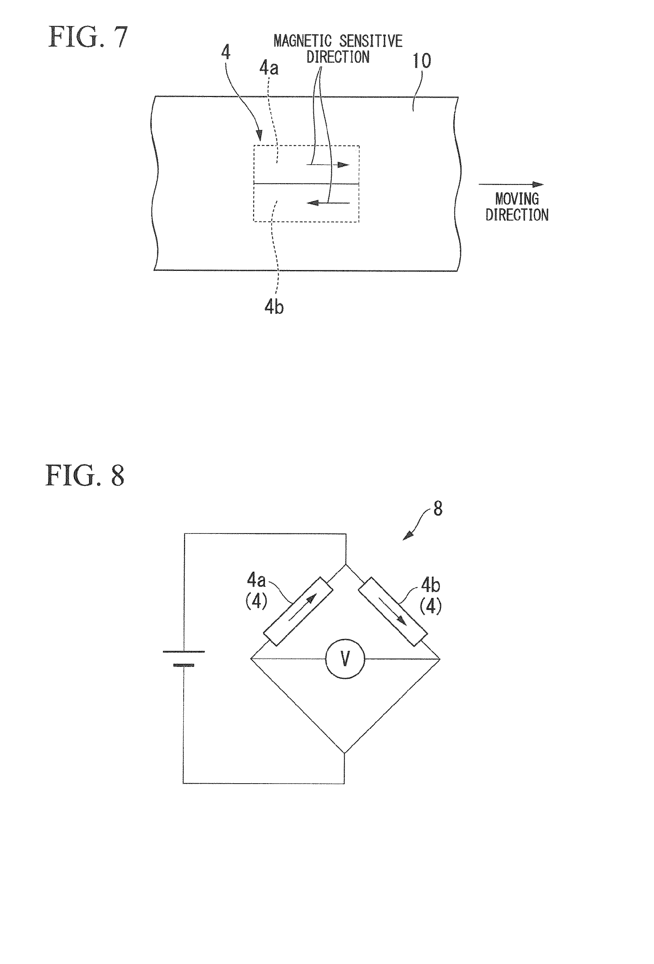

In the embodiment described above, although the magnetic sensor 4 has one magnetic resistance element, as shown in FIG 7, the magnetic sensor 4 may have two magnetic resistance elements.

Specifically, the magnetic sensor 4 has a first magnetic resistance element 4a and a second magnetic resistance element 4b. The first magnetic resistance element 4a and the second magnetic resistance element 4b are disposed so as to make the magnetic sensitive directions of them be opposite direction with each other. By disposing the first magnetic resistance element 4a and the second magnetic resistance element 4b so as to make the magnetic sensitive directions of them be opposite direction with each other, the noise effect caused by the environmental magnetic field and characteristics of the elements can be suppressed substantially.

As shown in FIG. 8, the magnetic resistance element of the magnetic sensor 4 may have the bridge circuit 8. In a case that two magnetic resistance element 4a and 4b (4) are included in the magnetic sensor 4, as shown in FIG. 8, the two magnetic resistance element 4a and 4b (4) are disposed so as to make the magnetic sensitive directions of them be opposite direction with each other. By the disposition, the noise effect caused by the environmental magnetic field and characteristics of the elements can be suppressed substantially. In a case that only one magnetic resistance element is included in the magnetic sensor 4, the magnetic resistance element is disposed at the position of the magnetic resistance element 4a.

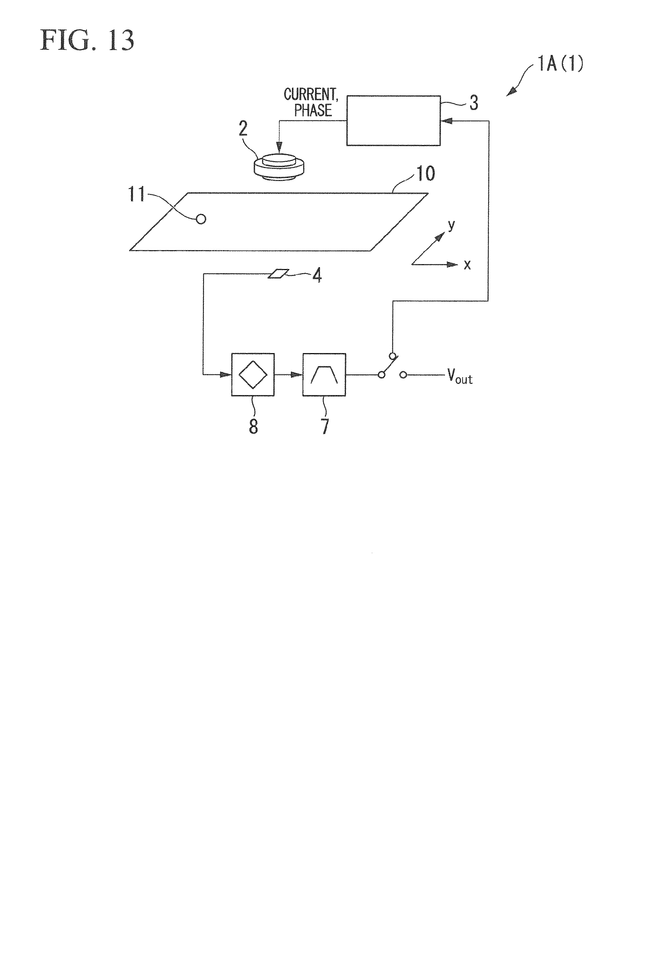

In the present embodiment described above, the current controller 6 makes the noise component included in the output signal from the magnetic sensor 4 be minimal by controlling the drive current and the phase of the noise reduction coil 5. However, the present invention is not restricted to the above-described embodiment. As shown in FIG. 13, the current controller 3 may control a drive current and a phase of the exciting coil 2 in accordance with the electrical signal from the magnetic sensor 4 to reduce the noise. Because the method of determining the drive current and the phase is the same as the method shown in FIG. 6, the description thereof will be omitted.

Specifically, in the conductive foreign material detecting apparatus 1A(1), the current controller 3 may make the noise component of the same frequency as the AC magnetic field other than the magnetic change be minimal by controlling the drive current and the phase of the exciting coil 2, the noise component is included in the output signal from the magnetic sensor 4.

Because steps of determining the drive current and the phase of the exciting coil 2 are the practically-same as the steps of determining the drive current and the phase of the noise reduction coil 5 (refer to FIG. 6), the detailed description thereof will be omitted.

Specifically, first, the current controller 3 obtains the current value having the minimal value of the noise output with changing the drive current. At this current value, the current controller 3 obtains the phase at which the noise output is minimal with changing the phase of the exciting coil 2. That is, the current controller 3 repeatedly searches the minimal value with changing the drive current and the phase, and the current controller 3 finally obtains the combination of the drive current and the phase at which the minimum value of the noise output is obtained. By the processing, the noise component included in the output signal from the magnetic sensor 4 can be minimized.

In the present embodiment described above, although the size of the exciting coil 2 is same as the size of the noise reduction coil 5, the same size is not necessarily required. For example, the diameter of the noise reduction coil 5 may be smaller than the diameter of the exciting coil 2. By making the diameter of the noise reduction coil 5 be smaller than the diameter of the exciting coil 2, the noise component of the output signal from the magnetic sensor 4 can be reduced effectively.

### (Second Embodiment)

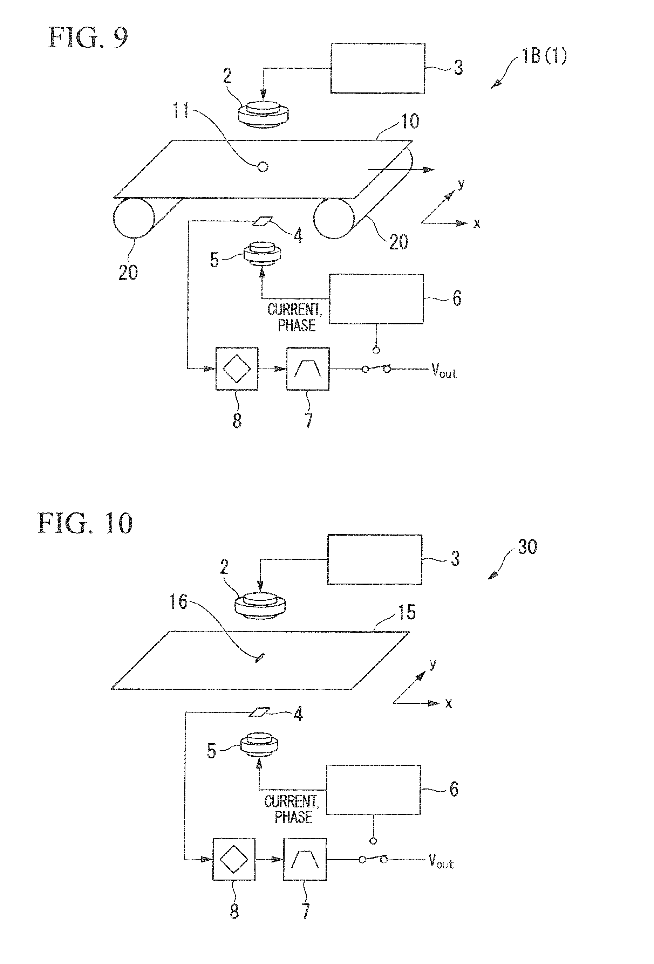

FIG. 9 is a drawing illustrating an example of a conductive foreign material detecting apparatus 1B(1) in a second embodiment. In this drawing, parts that correspond to those in the first embodiment are assigned the same reference numerals, and the descriptions thereof will be omitted.

The conductive foreign material detecting apparatus 1B(1) has a conveyance mechanism conveying the sheet 10. For example, the conveyance mechanism is conveyance roller 20. By the same method as FIG 1 and FIG. 2, the conductive foreign material 11 on the sheet 10 moving in one direction is detected. By inspecting with moving the sheet 10 by the conveyance mechanism, the inspection of the conductive foreign material 11 can be performed sequentially out of touch with the sheet 10, for example, without stopping a line in a point of production.

### [An Eddy Current Detecting Apparatus]

FIG. 10 is a drawing illustrating an example of an eddy current detecting apparatus 30 and illustrating a block diagram of the eddy current detecting apparatus 30 detecting a defection 16 on the surface of the metallic sheet 15 or in the metallic sheet 15. In this drawing, parts that correspond to those of the conductive foreign material detecting apparatus 1A(1) described above are assigned the same reference numerals, and the descriptions thereof will be omitted.

The eddy current detecting apparatus 30 includes an exciting coil 2, a current controller 3, a magnetic sensor 4, a noise reduction coil 5, and a current controller 6. The exciting coil 2 applied an AC magnetic field to the metallic sheet (metallic base substance) 15 through which the AC magnetic field can pass. The magnetic sensor 4 detects a magnetic change of the AC magnetic field caused by the defection 16 on the surface of the metallic sheet 15 or in the metallic sheet 15. The noise reduction coil 5 reduces noise component of the same frequency as the AC magnetic field other than the magnetic change by applying predetermined magnetic field to the AC magnetic field. The current controller 6 controls a drive current and a phase of the noise reduction coil 5.

When the eddy current detecting apparatus 30 detects the defection 16, the exciting coil 2 is driven by the current controller 3, and the AC magnetic field is applied. At this time, background noise is generated directly or indirectly in output from the magnetic sensor 4 by the AC magnetic field generated by the exciting coil 2. The frequency of the background noise is substantially same as that of the AC magnetic field. The noise reduction coil 5 is disposed so as to minimize the background noise.

In the eddy current detecting apparatus 30, the current controller 6 makes the noise component of the same frequency as the AC magnetic field other than the magnetic change be minimal by controlling the drive current and the phase of the noise reduction coil 5. The noise component is included in the output signal from the magnetic sensor 4.

Because the steps of determining the drive current and the phase of the noise reduction coil 5 is the same as that of the conductive foreign material detecting apparatus 1A(1) (refer to FIG. 6), the detail description thereof will be omitted.

In the present embodiment, first, the current controller 3 obtains the current value having a minimal value of the noise output V_{N} with changing the drive current I. At this current value, the current controller 3 obtains the phase at which the noise output V is minimal with changing the phase ϕ. That is, the current controller 3 repeatedly searches the minimal value with changing the drive current I and the phase ϕ, and the current controller 3 finally obtains the combination of the drive current I and the phase ϕ at which the minimum value of the noise output is obtained. By the processing, the noise component included in the output signal from the magnetic sensor 4 can be minimized.

When the eddy current detecting apparatus 30 detects the defection 16, the current controller 3 controls the exciting coil 2, and the AC magnetic field is applied to the metallic sheet 15. By applying the AC magnetic field to the defection 16 on the surface of the metallic sheet 15 or in the metallic sheet 15 from the exciting coil 2, the eddy current is changed in accordance with discontinuous part of the defection 16 and change of the magnetic field is generated. The magnetic sensor 4 is disposed immediately below the exciting coil 2 and below the metallic sheet 15 including the defection 16 so as to make magnetic sensitive direction of the magnetic sensor 4 be perpendicular to the AC magnetic field generated by the exciting coil 2.

The current controller 6 drives the noise reduction coil 5 by using the drive current and the phase obtained by the method described above at the time of reducing the background noise component. The current controller 6 corrects the background noise component of the same frequency as the AC magnetic field caused by the component affecting the output from the magnetic sensor 4 in accordance with the AC magnetic field from the exciting coil 2 by controlling the drive current and the phase. By this processing, the SNR which is a ratio of the output signal component and the noise component can be improved.

The electrical signal from the magnetic sensor 4 passes through the bandpass filter 7, and the noise caused by elements and environmental magnetic field is filtered. The current controller 6 detects the filtered electrical signal from the magnetic sensor 4. By this processing, the noise effect can be smaller, and the change of the magnetic field caused by the defection 16 on the surface of the metallic sheet 15 or in the metallic sheet 15 can be detected. Also, by controlling the drive current and the phase with respect to each apparatus, individual difference of the each apparatus can be decreased and the output signal component can be detected stably.

In FIG. 10, although the metallic sheet 15 is disposed below the exciting coil 2 and the magnetic sensor 4 is disposed immediately below the exciting coil 2 and below the metallic sheet 15 so as to make magnetic sensitive direction of the magnetic sensor 4 be perpendicular to the AC magnetic field generated by the exciting coil 2, the present invention is not restricted to this embodiment. For example, the magnetic sensor 4 and the noise reduction coil 5 may be disposed immediately below the exciting coil 2, and the metallic sheet 15 may be disposed further below.

### (Examples)

Examples for examining effect of the embodiments are described below. Although specific numerical values are described in the examples described below, these numeral values are merely examples and the present invention is not limited to the numeral values.

In a first example and a second example, the conductive foreign material detecting apparatus was used to control the drive current and the phase of the noise reduction coil in a state that the foreign material did not exist so as to make the noise component included in the output signal from the magnetic sensor be minimal.

### [First Example]

In the first example, as shown in FIG. 1, the conductive foreign material detecting apparatus having a giant magnetic resistance element (GMR) which is used as the magnetic sensor was used. The current controller was used to control the exciting coil of which internal diameter = 20 [mm], R = 0.19 [Ω], and L = 0.205 [mH] in conditions of 32.7661 [kHz], 129.3 Vp-p, and 0 degrees. The GMR of the magnetic sensor was used as a gauge of the bridge circuit. A distance between the exciting coil and the magnetic sensor was set about 6 [mm], and a distance between the noise reduction coil and the magnetic sensor was set about 4 [mm]. In a case of driving with same polar current, the magnetic field from the exciting coil and the magnetic field from the noise reduction coil were opposite direction with each other.

By the method described above, the combination of the driving current and the phase making the noise component be minimal was obtained. When the current controller was used to drive the noise reduction coil of which internal diameter = 20 [mm], R = 0.19 [Ω], and L = 0.205 [mH] in conditions of 32.7661 [kHz] (same frequency), 52.9 Vp-p, and 131 degrees, the output from the magnetic sensor was approximately same as the output before the exciting controller controls the exciting coil. Therefore, the noise component of the same frequency as the AC magnetic field was reduced.

### [Second Example]

In the second example, as shown in FIG. 7, the conductive foreign material detecting apparatus having two giant magnetic resistance elements (GMR) which are used as the magnetic sensor was used. The current controller was used to control the exciting coil of which internal diameter = 20 [mm], R = 0.19 [Ω], and L = 0.205 [mH] in conditions of 32.7661 [kHz], 129.3 Vp-p, and 0 degrees. The two GMR of the magnetic sensor were used as two gauges of electrical power supply of the bridge circuit, and bias magnetic fields applied to each of the two GMR were opposite direction with each other so as to make the magnetic sensitive directions of them be opposite direction with each other. A distance between the exciting coil and the magnetic sensor was set about 6 [mm], and a distance between the noise reduction coil and the magnetic sensor was set about 4 [mm]. In a case of driving with same polar current, the magnetic field from the exciting coil and the magnetic field from the noise reduction coil were opposite direction with each other.

By the method described above, the combination of the driving current and the phase making the noise component be minimal was obtained. When the current controller was used to drive the noise reduction coil of which internal diameter = 20 [mm], R = 0.19 [Ω], and L = 0.205 [mH] in conditions of 32.7661 [kHz] (same frequency), 27 Vp-p, and 13.2 degrees, the output from the magnetic sensor was approximately same as the output before the exciting controller controls the exciting coil. Therefore, the noise component of the same frequency as the AC magnetic field was reduced.

In a third example and a fourth example, the SNR was obtained by controlling a position of the conductive foreign material and comparing signal component in a position where amplitude of the output was maximum with noise component included in the output signal.

### [Third Example]

In the third example, as shown in FIG. 1, the conductive foreign material detecting apparatus having a giant magnetic resistance element (GMR) which is used as the magnetic sensor was used. The conductive foreign material detection of non-magnetic A1 ball of ϕ 3 [mm] was performed in the same condition as the first example. The conductive foreign material was disposed in a plane immediately above the magnetic sensor by about 1 [mm]. The conductive foreign material was moved through the position immediately above the magnetic sensor along with the magnetic sensitive direction of the magnetic sensor, and the output signal was detected.

The current controller was used to control the exciting coil of which internal diameter = 20 [mm], R = 0.19 [Ω], and L = 0.205 [mH] in conditions of 32.7661 [kHz] (same frequency), 52.9 Vp-p, and 131 degrees.

At this time, SNR of a signal passed an instrumentation amplifier (not shown) from the bridge circuit was 1.10. The signal from the instrumentation amplifier passed through a bandpass filter of which center frequency was 32.77 [kHz], and Q was about 30. SNR of the signal passed through the bandpass filter was 1.77. The signal from the bandpass filter passed through a crystal vibrator filter of which center frequency was 32.7661 [kHz]. SNR of the signal passed through the crystal vibrator filter was 13.8.

As the result described above, the current controller was used to control the noise reduction coil to reduce the noise component of the same frequency as the AC magnetic field other than the magnetic change caused by the conductive foreign material, effect of the background noise of which frequency was substantially same as the magnetic change of the signal component was suppressed.

Specifically, because the noise component of which frequency was different from that of the signal component was suppressed by narrowing bandwidth of passing frequency by using the bandpass filter, SNR which is a ratio of the output signal component and the noise component was improved.

### [Fourth Example]

In the fourth example, as shown in FIG. 7, the conductive foreign material detecting apparatus having two giant magnetic resistance elements (GMR) which are used as the magnetic sensor was used. The conductive foreign material detection of non-magnetic A1 ball of ϕ 3 [mm] was performed in the same condition as the second example. The conductive foreign material was disposed in a plane immediately above the magnetic sensor by about 1 [mm]. The conductive foreign material was moved through the position immediately above the magnetic sensor along with the magnetic sensitive direction of the magnetic sensor, and the output signal was detected.

The current controller was used to control the exciting coil of which internal diameter = 20 [mm], R = 0.19 [Ω], and L = 0.205 [mH] in conditions of 32.7661 [kHz] (same frequency), 27 Vp-p, and 13.2 degrees.

At this time, SNR of a signal passed an instrumentation amplifier from the bridge circuit was 2.25. The signal from the instrumentation amplifier passed through a bandpass filter of which center frequency was 32.77 [kHz], and Q was about 30. SNR of the signal passed through the bandpass filter was S.13. The signal from the bandpass filter passed through a crystal vibrator filter of which center frequency was 32.7661 [kHz]. SNR of the signal passed through the crystal vibrator filter was 36.8.

As the result described above, the current controller was used to control the noise reduction coil to reduce the noise component of the same frequency as the AC magnetic field other than the magnetic change caused by the conductive foreign material, effect of the background noise of which frequency was substantially same as the magnetic change of the signal component was suppressed.

Specifically, by disposing the magnetic sensor to make the magnetic sensitive directions of the two giant magnetic resistance elements were opposite direction with each other, the noise effect caused by the environmental magnetic field and characteristics of the elements was suppressed and SNR was improved.

As a reference experiment, the conductive foreign material detection of non-magnetic A1 ball of ϕ 1 [mm] was performed in the same condition as the second example. The conductive foreign material was disposed in a plane immediately above the magnetic sensor by about 1 [mm]. The conductive foreign material was moved through the position immediately above the magnetic sensor along with the magnetic sensitive direction of the magnetic sensor, and the output signal was detected. At this time, SNR of a signal passed from the bridge circuit through the instrumentation amplifier, the bandpass filter, and the crystal vibrator filter is 1.74. The center frequency of the bandpass filter was 32.77 [kHz], and Q of the bandpass filter was about 30. The center frequency of the crystal vibrator filter was 32.7661 [kHz]. For this reason, although the smaller foreign material can be detected, SNR becomes smaller.

While preferred embodiments of the invention have been described and illustrated above, it should be understood that these are exemplary of the invention and are not to be considered as limiting. Additions, omissions, substitutions, and other modifications can be made without departing from the scope of the present invention. Accordingly, the invention is not to be considered as being limited by the foregoing description, and is only limited by the scope of the appended claims.

## Claims

1. A conductive foreign material detecting apparatus comprising:
an exciting coil configured to apply an AC magnetic field to a base substance through which the AC magnetic field passes;
a magnetic sensor configured to detect a change of the AC magnetic field caused by a conductive foreign material on a surface of the base substance or in the base substance;
a noise reduction coil configured to reduce a noise of substantially the same frequency as the AC magnetic field other than the change of the AC magnetic field by generating predetermined magnetic field to the AC magnetic field; and
a current controller configured to control a drive current and a phase of the noise reduction coil so as to make the noise of substantially the same frequency as the AC magnetic field other than the change of the AC magnetic field be minimal.

2. The conductive foreign material detecting apparatus according to claim 1, further comprising any one of a bandpass filter and a lock-in amplifier,
wherein the current controller configured to detect output signal component from the magnetic sensor via the bandpass filter or the lock-in amplifier.

3. The conductive foreign material detecting apparatus according to claim 2, wherein
the bandpass filter includes a vibrator, and
the vibrator is any one of a crystal vibrator, a ceramic vibrator, and a silicon vibrator.

4. The conductive foreign material detecting apparatus according to claim 1, wherein
the magnetic sensor is any one of a magnetic resistance element of which electrical resistance changes in accordance with applied magnetic field and a magnetic impedance element of which electrical impedance changes in accordance with applied magnetic field.

5. The conductive foreign material detecting apparatus according to claim 4, wherein
the magnetic sensor includes a first magnetic resistance element and a second magnetic resistance element,
magnetic sensitive directions of the first magnetic resistance element and the second magnetic resistance element are opposite direction with each other.

6. The conductive foreign material detecting apparatus according to claim 1, further comprising a resonant circuit in which a capacitor is connected to the exciting coil.
